# EUROPEAN PATENT SPECIFICATION

(11) **EP 1 936 931 B1**
(45) Date of publication and mention of the grant of the patent: **15.09.2010**
(21) Application number: 06291989.9
(22) Date of filing: 19.12.2006
(51) Int. Cl.: H04M 3/30, G01R 31/11, H04B 3/46

(54) **Cable topology determination arrangement and method**
Kabeltopologiebestimmungsanordnung und -verfahren
Procédé et agencement de détermination de topologie de câble

(43) Date of publication of application: 25.06.2008
(73) Proprietor: Alcatel Lucent, 75008 Paris (FR)
(72) Inventor: Fossion, Marc, 5140 Ligny (BE); Duvivier, Michael, 6120 Nalinnes (BE)
(74) Representative: Narmon, Gisèle Marie Thérèse

(56) References cited:
- EP-A- 1 494 037
- GB-A- 1 515 850
- US-A- 5 481 195

## Description

### Field of the Invention

The present invention generally relates to topology determination in communication networks, in particular access networks like Digital Subscriber Line (DSL) networks. Topology determination is the art of discovering the cable plant topology of an operator's network, for instance discovering which lines form part of the same cable or cable binder, discovering the number and length of cascaded sections that constitute a cable, etc. Accurate and up-to-date knowledge of the cable plant topology is an important instrument for the operator, in particular in access networks where knowledge of the loop plant topology enables the operator to determine if a certain line is capable of supporting a new service requested by the end-user before the line is taken into service or upgraded with the new service. Knowledge of the cable plant topology further eases diagnose and fault localization on a line, and assists the operator in deployment issues like the installation of a new remote unit, e.g. a Very High Speed Digital Subscriber Line (VDSL) remote unit that has to be installed at a location in the network where it optimally covers a large number of end-users. Information on the cable topology, e.g. knowledge of which cables share the same binder, may further be useful in for instance crosstalk identification, i.e. estimation of the crosstalk coupling between lines in order to determine if a line can be used for a particular service, if a line can be upgraded to higher bit rate services, if dynamic spectrum management (DSM) algorithms have to be applied, etc.

### Background of the Invention

Cable topology determination is becoming a key instrument for operators in prequalification of lines for service deployment, line diagnose and fault localization, and network deployment in general.

As a result of triple play service deployment, i.e. concurrent delivery of voice, video and Internet services over a single line, operators are massively deploying Digital Subscriber Lines (DSL) such as Asymmetric Digital Subscriber Lines (ADSL) or Very High Speed Digital Subscriber Lines (VDSL). Pre-qualification of such lines, i.e. determining whether a line is capable of supporting an additional service like video with sufficient stability, is almost impossible today. Although standardized techniques like Single Ended Line Tests (SELT) or Dual Ended Line Tests (DELT) enable estimation of the loop length and of the channel transfer function of a DSL loop, the actual achievable bit rate on the line is usually affected by noise present at the end-user side which cannot be measured through SELT or DELT. The benefits of DELT as standardized in ITU's G.992.3 (ADSL2) and G.992.5 (ADSL2+) specifications for loop length and loop capacity estimation - the so called "Loop Diagnostics" - are for instance praised in *the white paper "Technician Dr. DSL - ADSL2 Modem Diagnostics Software for Field Testing" from Aware, downloadable* from the Internet via the following URL:
http://www.aware.com/products/dsi/whitepapers.htm
SELT on the other hand has been described and appraised extensively in *the white paper "*Single-Ended Loop Testing (SELT) - Expectations and Realities" from the authors Peter J.W. Melsa and Krista S. Jacobsen, and published in March 2003 by Texas Instruments*.* Measuring the noise present at end-user side requires monitoring the active DSL line over time, which is unacceptable for operators since users may temporarily experience low quality service and consequently decide to unsubscribe and/or switch to a competitive operator. A possible solution could consist in using the noise level measured on neighbouring DSL lines that already have the service for pre-qualification of the new line. The main obstruction here is the absence of knowledge of the cable plant topology from which it can be deduced which DSL lines are neighbouring, i.e. which DSL lines share the same cable or cable binder.

Another concern of DSL operators is line diagnose and fault localization. To avoid expensive and time consuming dispatching of technicians, SELT has been suggested in the DSL standards as a tool to diagnose faulty lines. In SELT, reflectometry is used from the central office in order to determine the nature and location of faults on the line. The accuracy and reliability of SELT for fault localization however turns out to be poor. This accuracy and reliability could be improved significantly if the results of SELT measurements on neighbouring lines could be combined with one another. Just like for loop pre-qualification, absence of knowledge of the cable plant topology hinders operators from comparing the SELT measurements on neighbouring lines in order to improve the accuracy and reliability of the diagnosis and fault localization on problematic DSL lines.

Further, knowledge of the cable plant topology would be meaningful in resolving network deployment issues like determining the optimal location of an additional remote unit in the network serving as many users as possible with optimal capacity.

Knowing the network topology is also a pre-requisite to enable introduction of new techniques like Dynamic Spectrum Management (DSM) algorithms that can double or triplicate the achievable bit rates on DSL lines.

One way to obtain information on the cable plant topology is based on maintenance of cable databases. Such databases are maintained by ILECs and contain records of the network design from which the constitution of cables or cable binders can be derived. For some operators, these loop databases are paper based and therefore not exploitable for automated loop pre-qualification, line diagnose, fault localization or dynamic network management. For some operators, these databases are already electronic but the information contained in the records is not up to date and therefore not reliable. The shortcomings of loop record databases, i.e. missing, incomplete or inaccurate records, are mentioned for instance in *section 4.1.2.2, third paragraph, of Muse document M C2.2 "Positioning paper on loop qualification and monitoring outlining general features the developed loop qualification and monitoring solution should fulfil" and in paragraph 2.3.5 of Martin Nilsson's 2005 Master Degree Thesis "Management of a DSL copper network using built-in loop qualification tools"*, retrievable via the Internet URL:
http://www.ee.kth.se/php/modules/publications/reports/2005/IR-SB-EX-0509.pdf
The loop databases are often encoded in a format and maintained on systems that relate to the POTS (Plain Old Telephony Service) management. The information is therefore not always useful for broadband service management. Extracting useful information from the cable databases may require re-ordering the information, decoding and re-formatting the information, etc. typically involving enormous amounts of effort. Another disadvantage of cable databases is that only the established ILECs (Incumbent Local Exchange Carriers) have access to it. Considering that CLECs (Competitive Local Exchange Carriers) as a result of loop unbundling have to rent or lease their lines from ILECs, the cable databases maintained by these ILECs may be expected to contain valuable information for CLECs, indicative for the quality of the rented or leased lines. The latter CLECs however are not granted access to the secret network topology information of the ILECs for obvious reasons.

An alternative, automated way to determine which lines share the same cable or cable binder is described in *European patent Application* EP 1 630 968*, entitled "Crosstalk Manager for Access Network Nodes*". According to this patent application, access nodes like DSLAMs are extended with a crosstalk agent that automatically performs crosstalk measurements each time the on/off state of a line changes in order to determine which lines are affected by the changing conditions and therefore likely to form part of the same cable or cable binder as the line that is switched on or off. Although the solution proposed in EP 1 630 968 overcomes most or all drawbacks of relying on inaccurate or outdated information in cable databases, the ability to perform automated crosstalk measurements must be implemented in software that adds complexity to the DSLAM or access node, and consequently renders such DSLAM or access node more expensive.

European Patent Application EP 1 494 037 "Method and Device for Single Ended Testing of a Line" from applicant Alcatel suggests in paragraph [0004] on page 2 that the topology of a line used for xDSL services can be derived form reflected pulses received during a Singe Ended Line Test. Paragraph [0021] on page 3 of the same patent application suggests that this technique can be applied to plural xDSL lines connected to a single Central Office. Office. AS a result thereof, the topology of the individual lines connected to that Central Office will be determined. However, the network topology, i.e. the joint topology of plural lines connected to a single Central Office involving aspects like for instance determining which lines share the same cable or cable binder, determining common or shared parts between xDSL lines, etc. cannot be determined though the technique known from EP 1 494 037 which is based on analysing the reflectograms received on each line separately from the other lines.

It is an objective of the present invention to disclose an arrangement for cable topology determination which overcomes the disadvantages and shortcoming of the above cited prior art solutions. In particular, it is an objective to provide an arrangement that automatically and reliably constructs the network topology by determining which lines form part of the same cable or cable binder without requiring significant changes to the access node software. It is a further objective to improve the accuracy, quality and reliability of loop pre-qualification, loop diagnose and fault localization, and to enable more optimal network deployment choices as well as faster introduction of new techniques like Dynamic Spectrum Management (DSM). Yet another objective is to provide a solution for loop topology determination available for both ILECs and CLECs, resulting in more fair competition between established, incumbent operators and new, competitive operators.

### Summary of the Invention

According to the present invention, the above defined objectives are realized by a cable topology determination arrangement for integration in or connection to an access node, as defined in claim 1, the arrangement comprising means for receiving Single Ended Line Test (SELT) reflectograms of the lines connected to the access node, means for correlation of the SELT reflectograms, and means for determining a topology of cables based on the correlation.

The basic idea underlying the invention is the insight that each line can be characterized through a reflectogram directly related to its topology. The reflectogram is received from SELT functionality already available in the access node, e.g. from the DSLAM MIB wherein the reflectometric SELT measurements are maintained. The reflectogram represents a pattern indicative for the cascade of cable sections. By correlating the reflectometric patterns measured on different lines, similarities in the reflections will provide further information on the topology of the network.

The current invention further relates to a corresponding cable topology determination method comprising, as defined by claim 5, the steps of receiving Single Ended Line Test (SELT) reflectograms of the lines connected to an access node, correlating at least two SELT reflectograms, and based thereon determining a topology of cables. An optional feature of the cable topology determination arrangement according to the present invention, is that it comprises means for identifying lines that share a same path based on the correlation. This optional feature is defined by claim 2.

Indeed, the correlation between reflectograms will enable to identify the lines, for instance copper pairs, that share the same path, i.e. cable or cable binder. Depending on the degree wherein two reflectograms match, the corresponding lines may be considered to share the same physical path, e.g. the same cable or the same cable binder.

Another optional feature of the cable topology determination arrangement according to the present invention is that this arrangement may further comprise means for receiving a priori information from an operator's cable database, and may have the ability to combine the a priori information with information extracted from the correlation. This feature is defined by claim 3.

Thus, a priori information such as the records on the topology of the network maintained in the operator's cable database may be combined with the correlation results of the reflectograms in order to further improve the reliability of the network topology determined according to the invention.

Yet another optional feature of the cable topology determination arrangement according to the present invention, is that this arrangement may further comprise means for crosstalk measurements between at least two lines, and may have the ability to combine information extracted from the crosstalk measurements with information extracted from the correlation.

Thus, information obtained through crosstalk measurements such as the ones described in European Patent Application EP 1 630 968 may advantageously be combined with the correlation results of the reflectograms and eventual a priori information available from the operator's cable databases in order to further improve the reliability of the network topology determined according to the present invention.

### Brief Description of the Drawings

Fig. 1 illustrates a cable topology and corresponding reflectogram, as used in embodiments of the present invention; and
Fig. 2 illustrates a cable plant topology and corresponding reflectograms determined according to an embodiment of the present invention.

### Detailed Description of Embodiment(s)

Today the main issue with the massive deployment of DSL is the explosion of maintenance activities. Solutions to cope with this problem must enable easy maintenance of the DSL network. The current invention concerns the capability to automatically construct the DSL network topology, i.e. the cable topology or at a lower level the binder topology, back from reflectometric SELT (Single Ended Line Test) measurements. Thanks to the reflectometric SELT measurements, the topology of for instance copper cable binders in the DSL network will be automatically constructed giving the operator access to valuable information for deployment rules, such as information on the interaction between signals of different customers sharing a same binder. The net result is an improvement of the reliability and accuracy of loop diagnostics and fault localization, and the service quality experienced by the end user.

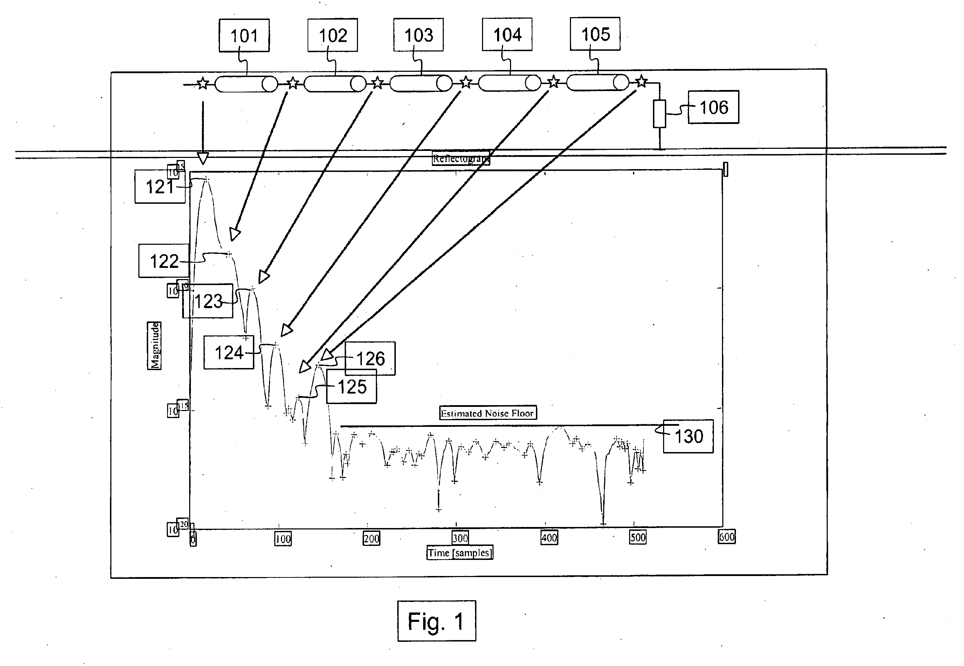

The underlying idea of the current invention is the consideration that the reflectogram obtained through SELT measurements constitutes a finger print for each line in the network, which is directly related to the line's topology. This is illustrated by Fig. 1 where a 1 km long copper loop is drawn that consists of five cascaded sections, respectively identified by 101, 102, 103, 104 and 105, and a loop termination represented by 106. In the corresponding reflectogram with noise floor 130, each of the peaks 121, 122, 123, 124, 125 and 126 can be associated with one of the cascaded sections. The reflectogram in other words can be considered as a kind of DNA pattern characterizing the cascade of sections in the line. By correlating those patterns measured for plural lines, similarities in the reflectograms will enable to identify lines sharing the same path. The SELT reflectograms needed for the correlation may be available, for instance at the DSLAM MIBs (Digital Subscriber Line Access Multiplexer Management Information Base), or may be measured instantaneously whenever the operator desires an update on the cable plant topology.

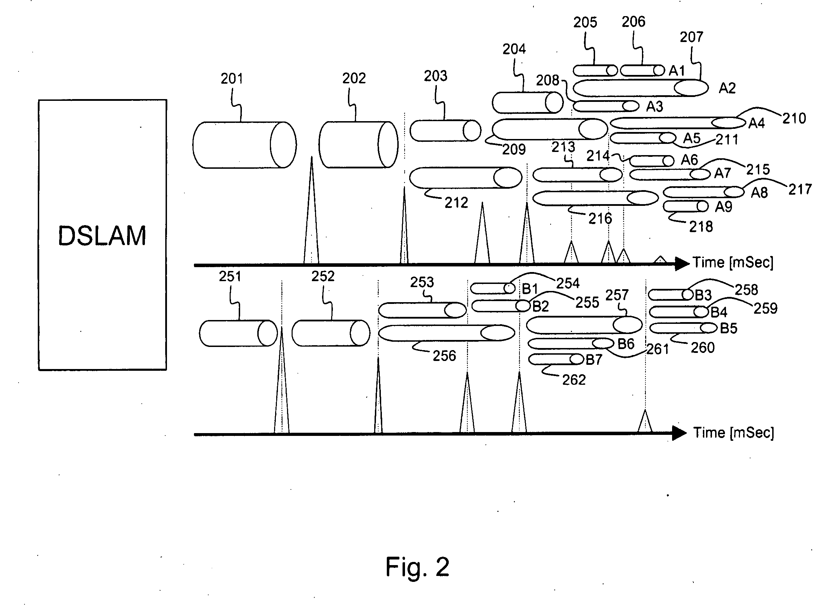

Thus, the present invention requires a SELT measurement per port. In Fig. 2 for instance, a DSLAM is shown with DSL lines to 16 subscribers, A1, A2, A3, A4, A5, A6, A7, A8, A9, B1, B2, B3, B4, B5, B6 and B7. The DSL line towards subscriber A1 consists of 6 cascaded sections 201, 202, 203, 204, 205 and 206. The DSL line towards subscriber A2 consists of 5 cascaded sections 201, 202, 203, 204 and 207. The DSL line towards subscriber A3 consists of 5 cascaded sections 201, 202, 203, 204 and 208. The DSL line towards subscriber A4 consists of 5 cascaded sections 201, 202, 203, 209 and 210. The DSL line towards subscriber A5 consists of 5 cascaded sections 201, 202, 203, 209 and 211. The DSL line towards subscriber A6 consists of 5 cascaded sections 201, 202, 212, 213 and 214. The DSL line towards subscriber A7 consists of 5 cascaded sections 201, 202, 212, 213 and 215. The DSL line towards subscriber A8 consists of 5 cascaded sections 201, 202, 212, 216 and 217. The DSL line towards subscriber A9 consists of 5 cascaded sections 201, 202, 212, 216 and 218. The DSL line towards subscriber B1 consists of 4 cascaded sections 251, 252, 253 and 254. The DSL line towards subscriber B2 consists of 4 cascaded sections 251, 252, 253 and 255. The DSL line towards subscriber B3 consists of 5 cascaded sections 251, 252, 256, 257 and 258. The DSL line towards subscriber B4 consists of 5 cascaded sections 251, 252, 256, 257 and 259. The DSL line towards subscriber B3 consists of 5 cascaded sections 251, 252, 256, 257 and 260. The DSL line towards subscriber B6 consists of 4 cascaded sections 251, 252, 256 and 261. The DSL line towards subscriber B7 consists of 4 cascaded sections 251, 252, 256 and 262.

A central agent, either located in the DSLAM drawn in Fig. 2 or in a network analyzer connected thereto, monitors the 17 DSL lines, collects the SELT reflectometric measurements for all 17 lines in the MIB and post-processes the reflectograms in order to identify shared cable connections and to produce the cable topology drawn in Fig. 2. The post-processing involves correlation of the 17 reflectograms measured for the different DSL lines. This may be done in an iterative process where the reflectograms of the first two DSL lines are correlated in order to identify shared cable section between them, e.g. the cable sections 201, 202, 203 and 204 will result in similar peaks in the SELT reflectograms measured on the DSL lines towards A1 and A2. Thereafter, the reflectogram measured on the third DSL line towards A3 may be correlated with the reflectograms of the first and second DSL lines in order to identify shared cable sections therewith, etc. As an alternative to the iterative correlation process, a matrix correlation may be calculated for the 17 DSL lines, followed by clustering of the loops with high correlations in binders. The choice of the correlation algorithm or expert system used to identify shared reflections in the bunch of reflectograms available at the central agent is merely an implementation aspect which will be influenced by the application or context wherein the current invention is deployed.

The invention results in access to more reliable, relevant and accurate information than the information available from traditional loop design records. In addition, it becomes possible through the reflectogram based correlations to track changes due to for instance field repairs and modifications. Correlation of problems between ports sharing the same binder sections leads to more accurate and valuable diagnostics of the problem with the advantage of localization. Further, information from one port can be used as a priori knowledge for another port sharing same or most of cables for bit rate prediction, line quality prediction, etc.

It is noticed that variant embodiments of the present invention may improve the accuracy and/or reliability of the topology determination by taking benefit of additional, available information such as a priori knowledge on the topology obtained from operator's loop topology databases, information obtained from crosstalk measurements between DSL lines, etc. The agent collecting correlating the reflectometric measurements according to the present invention, may therefore be equipped with interfaces towards the loop topology database and to the agent or equipment measuring the crosstalk between lines.

It is further acknowledged that the present invention requires a SELT measurement per port. Such a reflectometric SELT measurement is an intrusive test, possibly requiring interruption of the service for measurement of the echo response, e.g. with disconnected customer premises equipment. Such SELT measurements do not pose a problem for prequalification, or other instances where the line is not in service. In instances where the line is in service and it is unacceptable to disturb or interrupt the service, the current invention may rely on the reflectometric measurements obtained earlier, e.g. during prequalification of the loop, and stored in memory, e.g. the MIB.

Although the present invention has been illustrated by reference to specific embodiments, it will be apparent to those skilled in the art that the invention is not limited to the details of the foregoing illustrative embodiments, and that the present invention may be embodied with various changes and modifications without departing from the scope thereof. The present embodiments are therefore to be considered in all respects as illustrative and not restrictive, the scope of the invention being indicated by the appended claims rather than by the foregoing description, and all changes which come within the meaning and range of equivalency of the claims are therefore intended to be embraced therein. It will furthermore be understood by the reader of this patent application that the words "comprising" or "comprise" do not exclude other elements or steps, that the words "a" or "an" do not exclude a plurality, and that a single element, such as a computer program, a computer system, a processor, or another integrated unit may fulfil the functions of several means recited in the claims. Any reference signs in the claims shall not be construed as limiting the respective claims concerned. The terms "first", "second", third", "a", "b", "c", and the like, when used in the description or in the claims are introduced to distinguish between similar elements or steps and are not necessarily describing a sequential or chronological order.

## Claims

1. Cable topology determination arrangement for integration in or connection to an access node (DSLAM), said cable topology determination arrangement comprising means for receiving Single Ended Line Test SELT reflectograms of plural lines (A1, A2, ... A9; B1, B2, ... B7) connected to said access node (DSLAM),
**CHARACTERIZED IN THAT** said cable topology determination arrangement comprises means for correlation of at least two of said SELT reflectograms received from different lines of said plural lines, and means for determining a topology of cables (201, 202, ... 218; 251, 252, ...262) based on said correlation.

2. Cable topology determination arrangement according to claim 1,
**CHARACTERIZED IN THAT** said means for determining a topology comprise means for identifying lines (A1, A2) that share a same path (201, 202, 203, 204) based on said correlation.

3. Cable topology determination arrangement according to claim 1,
**CHARACTERIZED IN THAT** said arrangement further comprises means for receiving a priori information from an operator's cable database, and said means for determining a topology are adapted to combine said a priori information with information extracted from said correlation.

4. Cable topology determination arrangement according to claim 1 or claim 3,
**CHARACTERIZED IN THAT** said arrangement further comprises means for crosstalk measurements between at least two of said lines (A1, A2, ..., A9; B1, B2, ... B7), and said means for determining a topology are adapted to combine information extracted from said crosstalk measurements with information extracted from said correlation.

5. Cable topology determination method, said method comprising the step of receiving Single Ended Line Test SELT reflectograms of plural lines (A1, A2, ... A9; B1, B2, ... B7) connected to an access node (DSLAM),
**CHARACTERIZED IN THAT** said method further comprises the steps of correlating at least two of said SELT reflectograms received from different lines of said plural lines, and based thereon determining a topology of cables (201, 202, ..., 218; 251, 252, ... 262).

## Patentansprüche

1. Anordnung zur Bestimmung einer Kabel-Topologie für die Integration in oder den Anschluss an einen Zugangsknoten (DSLAM), wobei die besagte Anordnung zur Bestimmung einer Kabel-Topologie Mittel zum Empfangen von Reflektogrammen eines einseitigen Leitungstest SELT einer Mehrzahl von Leitungen (A1, A2, ... A9; B1, B2, ... B7), welche an den besagten Zugangsknoten (DSLAM) angeschlossen sind, umfasst,
**DADURCH GEKENNZEICHNET, DASS** die besagte Anordnung zur Bestimmung einer Kabel-Topologie Mittel zum Korrelieren von mindestens zwei der besagten von verschiedenen Leitungen der besagten Mehrzahl von Leitungen empfangenen SELT-Reflektogramme, sowie Mittel zum Bestimmen einer Topologie von Kabeln (201, 202, ... 218; 251, 252, ...262) auf der Basis der besagten Korrelation umfasst.

2. Anordnung zur Bestimmung einer Kabel-Topologie nach Anspruch 1,
**DADURCH GEKENNZEICHNET, DASS** die besagten Mittel zum Bestimmen einer Topologie Mittel zum Identifizieren von Leitungen (A1, A2), welche sich einen selben Pfad (201, 202, 203, 204) teilen, auf der Basis der besagten Korrelation umfassen.

3. Anordnung zur Bestimmung einer Kabel-Topologie nach Anspruch 1,
**DADURCH GEKENNZEICHNET, DASS** die besagte Anordnung weiterhin Mittel zum Empfangen von A-priori-Informationen von der Kabeldatenbank eines Betreibers umfasst, und dass die besagten Mittel zum Bestimmen einer Topologie dazu ausgelegt sind, die besagten A-priori-Informationen mit aus der besagten Korrelation extrahierten Informationen zu kombinieren.

4. Anordnung zur Bestimmung einer Kabel-Topologie nach Anspruch 1 oder Anspruch 3,
**DADURCH GEKENNZEICHNET, DASS** die besagte Anordnung weiterhin Mittel zur Messung des Übersprechens zwischen mindestens zwei der besagten Leitungen (A1, A2, ..., A9; B1, B2, ... B7) umfasst, und dass die besagten Mittel zum Bestimmen einer Topologie dazu ausgelegt sind, aus den besagten Messungen des Übersprechens extrahierte Informationen mit aus der besagten Korrelation extrahierten Informationen zu kombinieren.

5. Verfahren zur Bestimmung einer Kabel-Topologie, wobei das besagte Verfahren den Schritt des Empfangens von Reflektogrammen eines einseitigen Leitungstests SELT einer Mehrzahl von Leitungen (A1, A2, ... A9; B1, B2, ... B7), welche an einen Zugangsknoten (DSLAM) angeschlossen sind, umfasst,
**DADURCH GEKENNZEICHNET, DASS** das besagte Verfahren weiterhin die Schritte des Korrelierens von mindestens zwei der besagten von verschiedenen Leitungen der besagten Mehrzahl von Leitungen empfangenen SELT-Reflektogramme und des darauf basierenden anschließenden Bestimmens einer Topologie von Kabeln (201, 202, ..., 218; 251, 252, ... 262) umfasst.

## Revendications

1. Agencement de détermination de topologie de câbles pour l'intégration ou la connexion à un noeud d'accès (DSLAM), ledit agencement de détermination de topologie de câbles comprenant des moyens pour recevoir des réflectogrammes d'essai de ligne asymétrique SELT de plusieurs lignes (A1, A2, ... A9 ; B1, B2, ... B7) connectées audit noeud d'accès (DSLAM),
**CARACTERISE EN CE QUE** ledit agencement de détermination de topologie de câbles comprend des moyens pour corréler au moins deux desdits réflectogrammes SELT reçus depuis des lignes différentes desdites plusieurs lignes, et des moyens pour déterminer une topologie de câbles (201, 202, ... 218 ; 251, 252, ...262) sur la base de ladite corrélation.

2. Agencement de détermination de topologie de câbles selon la revendication 1,
**CARACTERISE EN CE QUE** lesdits moyens pour déterminer une topologie comprennent des moyens pour identifier les lignes (A1, A2) qui partagent un même chemin (201, 202, 203, 204) sur la base de ladite corrélation.

3. Agencement de détermination de topologie de câbles selon la revendication 1,
**CARACTERISE EN CE QUE** ledit agencement comprend en outre des moyens pour recevoir des informations a priori depuis une base de données de câbles d'opérateur, et lesdits moyens pour déterminer une topologie sont adaptés pour combiner lesdites informations a priori avec les informations extraites de ladite corrélation.

4. Agencement de détermination de topologie de câbles selon la revendication 1 ou 3,
**CARACTERISE EN CE QUE** ledit agencement comprend en outre des moyens pour effectuer des mesures diaphoniques entre au moins deux desdites lignes (A1, A2, ..., A9; B1, B2, ... B7), et lesdits moyens pour déterminer une topologie sont adaptés pour combiner les informations extraites desdites mesures diaphoniques avec les informations extraites de ladite corrélation.

5. Procédé de détermination de topologie de câbles, ledit procédé comprenant l'étape de réception de réflectogrammes d'essai de ligne asymétrique SELT de plusieurs lignes (A1, A2, ... A9 ; B1, B2, ... B7) connectées à un noeud d'accès (DSLAM),
**CARACTERISE EN CE QUE** ledit procédé comprend en outre les étapes de corrélation d'au moins deux desdits réflectogrammes SELT reçus depuis des lignes différentes desdites plusieurs lignes, et sur la base de cette corrélation, de détermination d'une topologie de câbles ((201, 202, ..., 218; 251, 252, ... 262).
